Europäisches Patentamt

European Patent Office

Office européen des brevets

(11) Veröffentlichungsnummer: **0 381 819**
**A1**

## (12) EUROPÄISCHE PATENTANMELDUNG

(21) Anmeldenummer: 89119046.4

(22) Anmeldetag: 13.10.89

(51) Int. Cl.5: **B32B 15/04, B29C 33/38**

(30) Priorität: 07.02.89 DE 3903544

(43) Veröffentlichungstag der Anmeldung:
16.08.90 Patentblatt 90/33

(84) Benannte Vertragsstaaten:
AT BE CH DE ES FR GB GR IT LI LU NL SE

(71) Anmelder: Repenning, Detlev, Dr.
Krabbenhöhe 12
D-2057 Reinbek(DE)

(72) Erfinder: Repenning, Detlev, Dr.
Krabbenhöhe 12
D-2057 Reinbek(DE)

(74) Vertreter: Niedmers, Ole, Dipl.-Phys. et al
Patentanwälte Niedmers & Schöning
Jessenstrasse 4
D-2000 Hamburg 50(DE)

(54) Werkzeug für die Elastomerverarbeitung.

(57) Es wird ein Werkzeug für die Elastomerverarbeitung, bestehend aus einem vorzugsweise metallischen Werkstoff, auf dem wenigstens teilweise eine physikalisch und/oder chemisch gegenüber dem Werkstoff unterschiedliche Eigenschaften aufweisende Schicht aufgebildet ist vorgeschlagen. Erfindungsgemäß besteht die Schicht aus einer mittels einem PVD/CVD Verfahren aufgebrachten Chrom oder Nickel enthaltenden Schicht.

## Werkzeug für die Elastomerverarbeitung

Die Erfindung betrifft Werkzeuge für die Elastomerverarbeitung, bestehend aus einem vorzugsweise metallischen Werkstoff, auf dem wenigstens teilweise eine physikalisch und/oder chemisch gegenüber dem Werkstoff unterschiedliche Eigenschaften aufweisenden Schicht aufgebracht ist.

Derartige Werkzeuge werden beispielsweise bei der Herstellung von Gummiteilen aller Art eingesetzt. Die Elastomerverarbeitung stellt die Hersteller von Formteilen aus den verschiedensten Elastomertypen vor sehr große Probleme, die bisher nicht gelöst worden sind. Diese Probleme bestehen im wesentlichen darin, daß bei der Herstellung der Elastomerteile die Formwerkzeuge sehr stark verschmutzen und das Entformungsverhalten sich sehr schnell beim Einsatz derartiger Werkzeuge verschlechtert. Zudem weisen die unterschiedlichen Elastomere aufgrund ihrer unterschiedlichen chemischen Zusammensetzung sowie ihrer beigegebenen Füllungen ein teilweise chemisch und mechanisch aggressives Verhalten gegenüber den Werkzeugen auf.

Um diese Probleme mit der Verschmutzung, der Entformbarkeit, der Korrosion, dem Verschleiß und der Reinigung von Werkzeugen, die bei der Elastomerverarbeitung verwendet werden, zum besseren zu wenden, hat man versucht, die Werkzeuge zu beschichten, beispielsweise mittels Kunststoff wie Teflon oder dgl.. Auch wurde versucht, die Probleme bei der Elastomerverarbeitung dadurch zu lösen, daß man das Werkzeug auf herkömmlichem Wege galvanisch mit einer Metallschicht aus einem anderen Metall als dem Werkstoff des Werkzeuges versah.

Alle bisherigen Versuche dieser Art, die oben erwähnten Probleme zu lösen, erwiesen sich bisher als wenig geeignet und brachten lediglich bezüglich einzelner der oben aufgeführten Probleme partielle Fortschritte.

Es ist Aufgabe der vorliegenden Erfindung, ein mit einer Schicht versehenes Werkzeug zu schaffen, das bei der Herstellung von Formteilen aus Elastomeren weniger verschmutzt, besser entformbar ist, eine geringere Korrosionsneigung hat und die Werkzeuge besser reinigen läßt als bisherige Werkzeuge dieser Art, das zudem für die unterschiedlichsten Elastomertypen bei gleich guten Eigenschaften einsetzbar ist und auch bei chlorierten Elastomeren und/oder mit Zusatzmitteln gefüllten Elastomeren keine Korrosionsprobleme zeigt.

Gelöst wird die Aufgabe gemäß der Erfindung dadurch, daß die Schicht aus einer mittels einem PVD/CVD-Verfahren aufgebrachten Chrom oder Nickel enthaltenden Schicht besteht.

Mit den erfindungsgemäßen Schichten wurden in langwierigen Versuchen und Untersuchungen sehr große Verbesserungen gegenüber den bekannten Schichten bei Werkzeugen für Elastomerverarbeitung erreicht, wobei insbesondere auch die Korrosionsprobleme bei chlorierten Elastomeren signifikant vermindert wurden und insgesamt auch eine deutliche Verbesserung der Verschmutzungsanfälligkeit der Werkzeuge sowie der Entformbarkeit der Elastomerteile aus den Werkzeugen erreicht wurde. Es zeigte sich beispielsweise, daß ein Werkzeug, das bei einer Beschichtung, wie sie im Stand der Technik bekannt ist, ca. alle 4 Stunden gereinigt werden mußte, während mit dem erfindungsgemäß ausgestalteten Werkzeug eine Reinigung lediglich nur noch im 8-Tage-Zyklus erforderlich ist, d. h. ein ungeheuer großer Standzeituwachs des Werkzeuges erfindungsgemäß erreicht worden ist.

Wie eingangs ausgeführt, werden bei der Elastomerverarbeitung, je nach Anwendungsgebiet, sehr unterschiedliche Elastomere bzw. unterschiedliche Kautschuktypen eingesetzt, die sich in bezug auf ihre Zusammensetzung und ihr chemisches und physikalisches Verhalten sehr stark unterscheiden können. Derartige Kautschuktypen sind beispielsweise zu unterteilen in polare, unpolare, schwefel-oder peroxidisch vernetzte Elastomere bzw. Kautschuktypen, die wiederum mit bestimmten Mitteln wie Ruß, Kaolin oder anderen Mitteln gefüllt sein können. Zusätzlich gibt es die sehr schwer durch die Werkzeuge für die Elastomerverarbeitung beherrschbaren Elastomer- bzw. Kautschuktypen, wie chlorierte und fluorierte Elastomere bzw. Kautschuke.

Es hat sich gezeigt, daß es beispielsweise für bestimmte Elastomertypen vorteilhaft ist, daß Chrom in Form einer Chromnitridverbindung auszubilden, um die Probleme wie Verschmutzung, Entformbarkeit, Korrosionsverhalten und Reinigung einer Verbesserung zuzuführen.

Für bestimmte andere Elastomere hat es sich als vorteilhaft herausgestellt, Nickel zusammen mit der Chromnitridverbindung zu einer Nickel-Chromnitriddispersionsschicht auszubilden, wobei über den Nickelgehalt in einer Chromnitridschicht die Entformbarkeit von Fluor-Kautschuktypen wie FKM, FPM, CFM sich mit sehr großem Erfolg und Genauigkeit steuern läßt.

Bei wieder anderen Elastomerzusammensetzungen ist es vorteilhaft, das Chrom und das Nickel in Form einer Nikkel-Chromlegierung zum Aufbau der Schicht zu verwenden.

Bei einer anderen vorteilhaften Ausgestaltung des Werkzeugs wird das Chrom in Form einer Chrom-Keramik-Oxyid-, Nitrid-, Carbid- und/oder Boridverbindung, nachfolgend Chrom-Ceride genannt, zur Bildung der Schicht verwendet, wobei je nach Anwendungsfall die unterschiedlichsten Ceride ausgewählt werden können.

Bei einer zusammengesetzten Schicht des erfindungsgemäßen Werkzeuges kann vorteilhafterweise der Chromnitrid- oder der Chromgehalt zum Nickelgehalt in einem Verhältnis von 0 bis 100 % variiert werden, um die entsprechenden gewünschten chemischen und physikalischen Eigenschaften der Werkzeuge bzw. deren Schicht für die Elastomerverarbeitung zu erreichen.

Es hat sich jedoch als vorteilhaft herausgestellt, beispielsweise bei einer Schicht des Werkzeuges aus Chromnitrid und Nickel, das Verhältnis von Chromnitrid und Nickel bei 60 zu 40 % auszuwählen, was insbesondere für eine disperse Mischung aus Chromnitrid und Nickel gilt. Bei einem derartigen Mischungsverhältnis und einer derartigen Zusammensetzung wurde für einige Elastomertypen, die mit dem erfindungsgemäßen Werkzeug verarbeitet wurden, eine bis zu 50-fach längere Standzeit der Werkzeuge in bezug auf den zunehmenden Verschmutzungsgrad erreicht.

Gemäß einer vorteilhaften anderen Ausgestaltung des Werkzeugs enthält die Schicht zusätzlich Kohlenstoff und/oder Stickstoff, mit dem bestimmte Eigenschaften der Schicht des Werkzeugs in bezug auf ihre Elastizität, ihre Härte und ihre Reibeigenschaften, je nach verwendetem Elastomer und Anwendungsgebiet, erreichbar sind.

Vorzugsweise wird dabei die Schicht durch eine Chromkohlenstoff-Nickelverbindung gebildet, wobei aber auch dispers gelöster Kohlenstoff in dieser nicht enthalten sein kann. Je nach Anwendungsfall und verwendetem Elastomer kann der Chromkohlenstoff und Nickelanteil zur Ausbildung der Schicht in einem Verhältnis von 0 bis 100 % variiert werden.

Dabei wird die Schicht gemäß einer vorteilhaften Ausgestaltung des Werkzeuges durch eine $Cr_3C_2$-Ni Verbindung gebildet.

Zusätzlich oder alternativ enthält die das Werkzeug wenigstens teilweise umhüllende Schicht anstelle des Stickstoffs und des Kohlenstoffs Sauerstoff, wobei bei einer sich in Versuchen als besonders vorteilhaft herausgestellten Ausgestaltung der Schicht des Werkzeugs herausgestellt hat, daß sich sehr gute Erfolge im Sinne der obigen Probleme durch einen Sauerstoffgehalt der Schicht zwischen 0 bis 15 %, des Kohlenstoffgehaltes zwischen 0 bis 40 % und des Stickstoffgehaltes zwischen 0 und 60 % erreichen ließen.

Das erfindungsgemäße Werkzeug wird mittels der an sich bekannten PVD oder CVD-Verfahren hergestellt. Bei der Durchführung der Versuche und Untersuchungen zur Optimierung der erfindungsgemäßen Beschichtungen stellte sich heraus, daß das PVD-Verfahren sehr wirksam ist, insbesondere das sogenannten Arc-Ionplating Verfahren. Dabei wurden zur Herstellung der Beschichtungen auf dem Werkzeug, das als Substrat in eine Beschichtungskammer eingebracht wird, als Targets sowohl Legierungen der Metalle Chrom und Nickel als auch die reinen Metalle Chrom und Nickel eingesetzt. Zur Erzeugung einer stickstoffhaltigen Schicht wird Stickstoff als Reaktivgas in die Beschichtungskammer eingeleitet, für die Ausbildung kohlenstoffhaltiger Schichten Methan, Azetylen oder andere Kohlenwasserstoffe.

In der folgenden Tabelle sind Beispiele aufgeführt, wie für unterschiedliche Elastomere die Schichtzusammensetzungen variieren.

3

| Elastomer | Schicht | Werkzeug | Stck. | Ausschuß | R-Zykl. |
|---|---|---|---|---|---|
| EPDM-Peroxid | 5N/5C | Kabeldurchführung | 16 fach | < 1 % | 8h-4Wo |
| ACM Acrylat + Chlorhalt. Komonomere | 6N | Kerne | | | |
| ECO | 6/6N 5N, 46N | Teller O-Ringe | 30 Stck. | 30 <-5 % | 3-4Wo |
| ECO FPM NBR | TiN 6N/7 46N | O-Ringe Wellenringdichtg. O-Ringe | 1 Stck. 1 Stck. 1 Paar | 30 <-5 % | 2-3Wo keine Verschmutz. |
| Elastomer | Schicht | Werkzeug | Stck. | Ausschuß | R-Zykl. |
| PUR NBR | TiN 5N ppN-6N | Türstopper O-Ring-Werkz.m. hohem Rußanteil | 1 W 2 W | | |

| Elastomer | Entformung | Qual. | Bemerkungen |
|---|---|---|---|
| EPDM-Peroxid | + + + | + + + | |
| ACM Acrylat + Chlorhalt. Komonomere | + + + | | |
| ECO | + + + | + + + | beste Ergebnisse mit 6N, keine Korros. 46N schlecht |
| ECO FPM | + + | + + | 6N sehr gut s.o. |
| NBR | | + + + | gutes Fließverhalten - jedoch keine stark verschmutzenden Sorten |
| Elastomer | Entformung | Qual. | Bemerkungen |
| PUR | + + + + + | + + + + + | Korrosion stark vermindert |
| NBR | | | Riefen i.d. Kavitäten, daher unbrauchbar |

## Ansprüche

1. Werkzeug für die Elastomerverarbeitung, bestehend aus einem vorzugsweise metallischen Werkstoff, auf dem wenigstens teilweise eine physikalisch und/oder chemisch gegenüber dem Werkstoff unterschiedliche Eigenschaften aufweisende Schicht aufgebracht ist, dadurch gekennzeichnet, daß die Schicht aus einer mittels einem PVD/CVD-Verfahren aufgebrachten Chrom oder Nickel enthaltenden Schicht besteht.

2. Werkzeug nach Anspruch 1, dadurch gekennzeichnet, daß das Chrom in Form einer Chromnitridverbindung vorliegt.

3. Werkzeug nach Anspruch 2, dadurch gekennzeichnet, daß Nickel zusammen mit der Chromnitridverbindung eine Nickel-Chromnitriddispersionsschicht bildet.

4. Werkzeug nach Anspruch 1, dadurch gekennzeichnet, daß Chrom und Nickel in Form einer Nickel-Chrom-Legierung die Schicht bilden.

5. Werkzeug nach Anspruch 1, dadurch gekennzeichnet, daß Chrom in Form einer Chrom-Keramik-Oxyid-, Nitrid- und/oder Boridverbindung die Schicht bildet.

6. Werkzeug nach Anspruch 3, dadurch gekennzeichnet, daß die Schicht durch Chromnitird und Nickel in einem Verhältnis von 0 bis 100 % gebildet wird.

7. Werkzeug nach Anspruch 6, dadurch gekennzeichnet, daß das Verhältnis Chromnitrid zu Nickel 60 zu 40 % ist.

8. Werkzeug nach Anspruch 4, dadurch gekennzeichnet, daß die Schicht durch Chrom und Nickel in einem Verhältnis von 0 bis 100 % gebildet wird.

9. Werkzeug nach einem oder mehreren der Ansprüche 1 bis 8, dadurch gekennzeichnet, daß die Schicht Kohlenstoff enthält.

10. Werkzeug nach Anspruch 9, dadurch gekennzeichnet, daß die Schicht durch eine Chromkohlenstoff-Nickelverbindung gebildet wird.

11. Werkzeug nach Anspruch 10, dadurch gekennzeichnet, daß die Schicht durch Chromkohlenstoff und Nickel in einem Verhältnis von 0 bis 100 % gebildet wird.

12. Werkzeug nach einem oder beiden der Ansprüche 10 oder 11, dadurch gekennzeichnet, daß die Schicht durch eine $Cr_3C_2$-Ni Verbindung gebildet wird.

13. Werkzeug nach einem oder mehreren der Ansprüche 1 bis 12, dadurch gekennzeichnet, daß die Schicht Sauerstoff enthält.

14. Werkzeug nach Anspruch 13, dadurch gekennzeichnet, daß der Sauerstoffgehalt der Schicht zwischen 0 bis 15 %, der Kohlenstoffgehalt zwischen 0 bis 40 % und der Stickstoffgehalt zwischen 0 bis 60 % liegt.

## EINSCHLÄGIGE DOKUMENTE

EP 89119046.4

| Kategorie | Kennzeichnung des Dokuments mit Angabe, soweit erforderlich, der maßgeblichen Teile | Betrifft Anspruch | KLASSIFIKATION DER ANMELDUNG (Int CI⁵) |
|---|---|---|---|
| A | <u>DE - A1 - 3 712 128</u><br>(OPT ENGINEERING)<br> * Spalte 2, Zeilen 22-60;<br>Spalte 3, Zeilen 24-29 *<br>-- | 1-14 | B 32 B 15/04<br>B 29 C 33/38 |
| A | <u>US - A - 3 904 382</u><br>(BELTRAN)<br> * Spalte 1, Zeile 56 - Spalte<br>3, Zeile 23 *<br>-- | 1-14 | |
| A | <u>US - A - 3 704 116</u><br>(PARIS)<br><br>---- | | |

| RECHERCHIERTE SACHGEBIETE (Int CI⁵) |
|---|
| B 32 B 15/00<br>B 29 C 33/00<br>C 23 C 30/00 |

Der vorliegende Recherchenbericht wurde für alle Patentansprüche erstellt

| Recherchenort | Abschlußdatum der Recherche | Prüfer |
|---|---|---|
| WIEN | 27-03-1990 | ONDER |